# EUROPEAN PATENT APPLICATION

(11) **EP 4 727 330 A1**
(43) Date of publication of application: **15.04.2026**
(21) Application number: 25306622.9
(22) Date of filing: 02.10.2025
(51) Int. Cl.: H10W 90/10, H10W 90/20

(54) **POWER MODULE FOR SOLID-STATE CIRCUIT BREAKER**

(30) Priority: 09.10.2024 CN 202411404852
(71) Applicant: SCHNEIDER ELECTRIC INDUSTRIES SAS, 92500 Rueil-Malmaison (FR)
(72) Inventor: LIU, Chenyang, Shanghai, 201203 (CN); LI, Ning, Shanghai, 201203 (CN); SUN, Hongzhi, Shanghai, 201203 (CN); BI, Baoyun, Shanghai, 201203 (CN); CHEN, Jiamin, Shanghai, 201203 (CN); LIU, Jiawei, Shanghai, 201203 (CN); JANINET, Louis, 13290 Aix-en-Provence (FR)
(74) Representative: Manitz Finsterwald Patent- und Rechtsanwaltspartnerschaft mbB

(57) **Abstract**

A power module for a solid-state circuit breaker, including: first and second substrates; first and second terminals; and a chip assembly disposed between the first and second substrates. The chip assembly includes: a plurality of bottom-side transistors having drains electrically coupled to a first substrate and including first and second sets of bottom-side transistors; a plurality of top-side transistors having drains electrically coupled to a second substrate and including first and second sets of top-side transistors; a gate drive board including bottom-side and top-side metal layers; and first and second metal connectors disposed on opposite sides of the gate drive board, the first metal connector being electrically coupled to sources of the first set of bottom-side transistors and the first set of top-side transistors, the second metal connector being electrically coupled to sources of the second set of bottom-side transistors and the second set of top-side transistors.

## Description

### FIELD

Embodiments of the present disclosure generally relate to the technical field of solid-state circuit breakers, and more particularly, to a power module for a solid-state circuit breaker.

### BACKGROUND

A conventional miniature circuit breaker has a low on-resistance, for example, a 63A miniature circuit breaker has an on-resistance of about 0.9-1 milliohms. Currently produced SiC MOSFET single transistor has a large on-resistance, for example, a 1200V SiC MOSFET single transistor has a minimum on-resistance of about 7 milliohms. Therefore, if the SiC MOSFET is adopted to achieve an on-resistance similar to that of the miniature circuit breaker, a plurality of SiC MOSFETs need to be connected in parallel. However, the large number of single transistors connected in parallel will cause switch consistency to be difficult to achieve, and a problem of poor integration will occur.

In a conventional power module, a single-layer power chip is usually mounted on a direct bonded copper (DBC) substrate, which occupies a large area, has poor heat dissipation performance, and has poor current balance performance. In addition, in a conventional stacked chip architecture, a half-bridge structure is usually adopted, however, the half-bridge structure cannot achieve bidirectional turn-off, and does not conform to a use scenario of a solid-state circuit breaker.

### SUMMARY

An object of the present disclosure is to provide a power module for a solid-state circuit breaker to at least partially solve above problems and other potential problems.

In a first aspect of the present disclosure, a power module for a solid-state circuit breaker is provided. The power module includes a first substrate and a second substrate stacked on each other; a first terminal electrically coupled to the first substrate and a second terminal electrically coupled to the second substrate; and a chip assembly disposed between the first substrate and the second substrate. The chip assembly includes: a plurality of bottom-side transistors having drains electrically coupled to the first substrate and including a first set of bottom-side transistors and a second set of bottom-side transistors; a plurality of top-side transistors having drains electrically coupled to the second substrate and including a first set of top-side transistors and a second set of top-side transistors; a gate drive board including a drive board insulating layer, and bottom-side and a top-side metal layer disposed on opposite surfaces of the drive board insulating layer, the bottom-side metal layer electrically being coupled to gates of the plurality of bottom-side transistors, the top-side metal layer electrically being coupled to gates of the plurality of top-side transistors; and a first metal connector and a second metal connector disposed on opposite sides of the gate drive board, the first metal connector electrically coupled to sources of the first set of bottom-side transistors and the first set of top-side transistors, the second metal connector electrically coupled to sources of the second set of bottom-side transistors and the second set of top-side transistors.

In some embodiments, the first substrate includes a first insulating layer, and a first metal layer and a second metal layer disposed on opposite surfaces of the first insulating layer, the second metal layer being electrically coupled to drains of the plurality of bottom-side transistors; and wherein the second substrate includes a second insulating layer, and a third metal layer and a fourth metal layer disposed on opposite surfaces of the second insulating layer, the third metal layer facing the second metal layer and being electrically coupled to drains of the plurality of top-side transistors.

In some embodiments, each of the first substrate and the second substrate includes a direct bonded copper (DBC) substrate.

In some embodiments, the first terminal is electrically coupled to the second metal layer.

In some embodiments, the power module further includes a terminal connection layer disposed between the second substrate and the chip assembly and electrically coupled to the third metal layer and the drains of the plurality of top-side transistors, wherein the second terminal is electrically coupled to the terminal connection layer.

In some embodiments, the terminal connection layer includes a copper foil.

In some embodiments, the power module further includes a plurality of top-side spacers disposed between the terminal connection layer and each of the first metal connector and the second metal connector.

In some embodiments, the power module further includes a plurality of bottom-side spacers disposed between the first substrate and each of the first and second metal connector.

In some embodiments, Kelvin electrodes of the plurality of bottom-side transistors are led out through metal layers on the plurality of bottom-side spacers, and Kelvin electrodes of the plurality of top-side transistors are led out through the first metal connector and the second metal connector.

In some embodiments, the gate drive board includes a plurality of segments disposed side-by-side between the first metal connector and the second metal connector and spaced apart from each other; and wherein the power module further includes a bottom-side connector electrically connected to the bottom-side metal layer of each of the plurality of segments and a top-side connector electrically connected to the top-side metal layer of each of the plurality of segments.

In some embodiments, the bottom-side connector includes a plurality of portions for connecting bottom-side metal layers of adjacent segments, and the top-side connector includes a plurality of portions for connecting top-side metal layers of adjacent segments.

In some embodiments, each of the gate drive board, the bottom-side connector, and the top-side connector includes a direct bonded copper (DBC) substrate.

In some embodiments, the gates of the plurality of bottom-side transistors are led out through bottom-side connectors, and the gates of the plurality of top-side transistors are led out through top-side connectors.

In some embodiments, each of the first metal connector and the second metal connector includes a copper foil.

In some embodiments, paraffin is disposed inside the copper foil.

In some embodiments, each of the plurality of bottom-side transistors and the plurality of top-side transistors is a SiC transistor.

In a second aspect of the present disclosure, there is provided a solid-state circuit breaker including the power module of the first aspect of the present disclosure.

The power module of embodiments of the present disclosure can realize a bidirectional turn-off function with a small on-resistance, and is suitable for being applied to the solid-state circuit breaker. In addition, specific arrangement of the chip assembly in the power module of embodiments of the present disclosure can reduce parasitic parameters of the entire power module to a lower level, which significantly improves current balancing performance, thereby achieving better turn-off performance with fewer transistors. In addition, the specific arrangement of the chip assembly in the power module of embodiments of the present disclosure enables transistors to realize double-sided heat dissipation, thereby optimizing thermal resistance and heat capacity and improving heat dissipation performance. In addition, an integration level of the power module of embodiments of the present disclosure is significantly improved, and can be manufactured to be smaller in size.

It should be understood that content described in this content section is not intended to limit key features or important features of embodiments of the present disclosure, nor is it intended to limit the scope of the present disclosure. Other features of the present disclosure will be readily understood from the following description.

### BRIEF DESCRIPTION OF DRAWINGS

The above and other features, advantages and aspects of embodiments of the present disclosure will become more apparent with reference to the following detailed description taken in conjunction with drawings. In the drawings, the same or similar reference numerals denote the same or similar elements, wherein:
FIG. 1 illustrates a schematic structural diagram of a power module for a solid-state circuit breaker according to some embodiments of the present disclosure;
FIGS. 2 and 3 illustrate exploded schematic views of the power module shown in FIG. 1 along different viewing angles;
FIG. 4 illustrates a further exploded schematic view of the power module shown in FIG. 3;
FIGS. 5 and 6 illustrate schematic structural diagrams of an intermediate layer of a chip assembly in the power module shown in FIG. 4 along different viewing angles;
FIG. 7 illustrates a schematic structural diagram of a lower layer of a chip assembly in the power module shown in FIG. 4;
FIG. 8 illustrates a schematic structural diagram of an upper layer of a chip assembly in the power module shown in FIG. 4;
FIGS. 9 to 14 illustrate a manufacturing process of a power module according to some embodiments of the present disclosure.

### Reference Number Description:

10 power module; 11 first substrate; 12 second substrate; 13 chip assembly; 14 terminal connection layer;
110 first insulating layer; 111 first metal layer; 112 second metal layer;
120 second insulating layer; 123 third metal layer; 124 fourth metal layer;
130 intermediate layer; 131 lower layer; 132 upper layer;
151 first terminal; 152 second terminal;
1300 gate drive board; 1300_1, 1300_2, 1300_3, 1300_4 segment;
1301 first metal connector; 1302 second metal connector; 1303 driver board insulating layer; 1305 bottom metal layer; 1306 top metal layer;
1310 a plurality of bottom-side transistors; 1311 a first set of bottom-side transistors; 1312 a second set of bottom-side transistors;
1320 a plurality of top-side transistors; 1321 a first set of top-side transistors; 1322 a second set of bottom-side transistors;
1313, 1323 drain; 1314, 1324 source; 1315, 1325 gate;
1316 bottom-side connector; 1317 bottom-side spacer;
1326 top-side connector; 1327 top-side spacer.

### DETAILED DESCRIPTION

Embodiments of the present disclosure will be described in more detail below with reference to the drawings. Although embodiments of the present disclosure are shown in the drawings, it should be understood that the present disclosure may be implemented in various forms and should not be limited by the embodiments set forth herein. Rather, these embodiments are provided to make the present disclosure more thorough and complete, and can fully convey a scope of the present disclosure to those skilled in the art.

As used herein, the term "include" and variations thereof means open inclusive, i.e., "include but not limited to". Unless specifically stated, the term "or" means "and/or". The term "based on" means "based at least in part on". The terms "an example embodiment" and "an embodiment" mean "at least one example embodiment". The term "another embodiment" means "at least one further embodiment". The terms "first," "second," and the like may refer to different or identical objects.

As mentioned briefly above, in a conventional power module, a single-layer power chip is usually mounted on a DBC substrate, and this arrangement occupies a large area, has poor heat dissipation performance, and has poor current balance performance; in addition, in a conventional stacked chip architecture, a half-bridge structure is usually adopted, however, the half-bridge structure cannot achieve bidirectional turn-off, and does not conform to a use scenario of a solid-state circuit breaker. Embodiments of the present disclosure provide a power module for a solid-state circuit breaker, which can achieve a bidirectional turn-off function with a small on-resistance, improve current balance performance, achieve better heat dissipation performance, and reduce the size of the module. Next, embodiments of the present disclosure will be described with reference to the drawings.

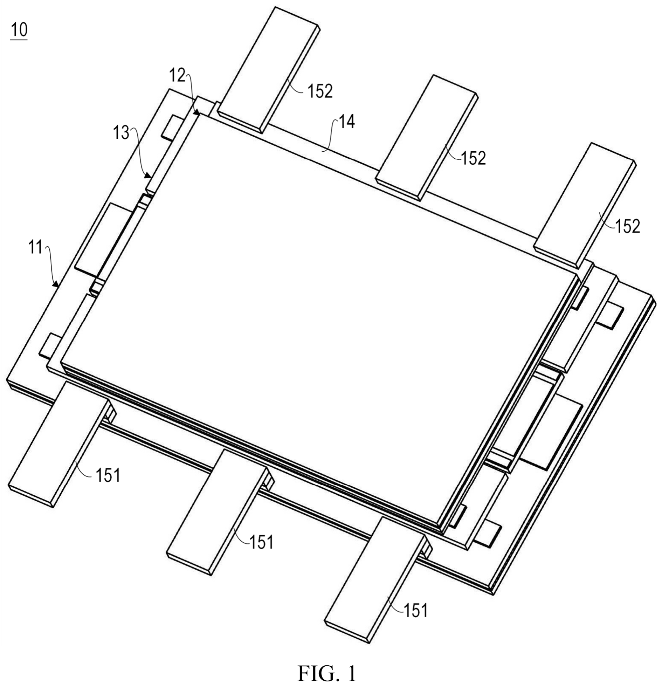

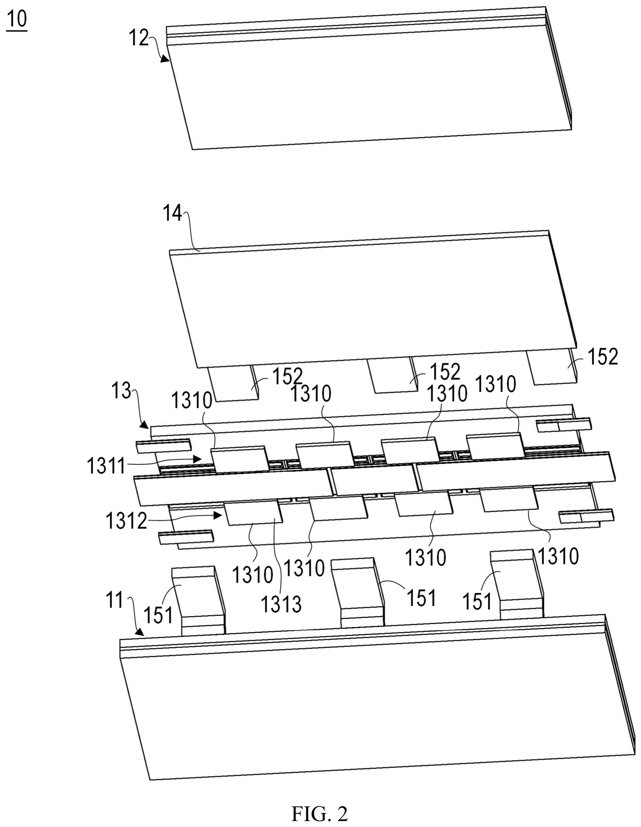

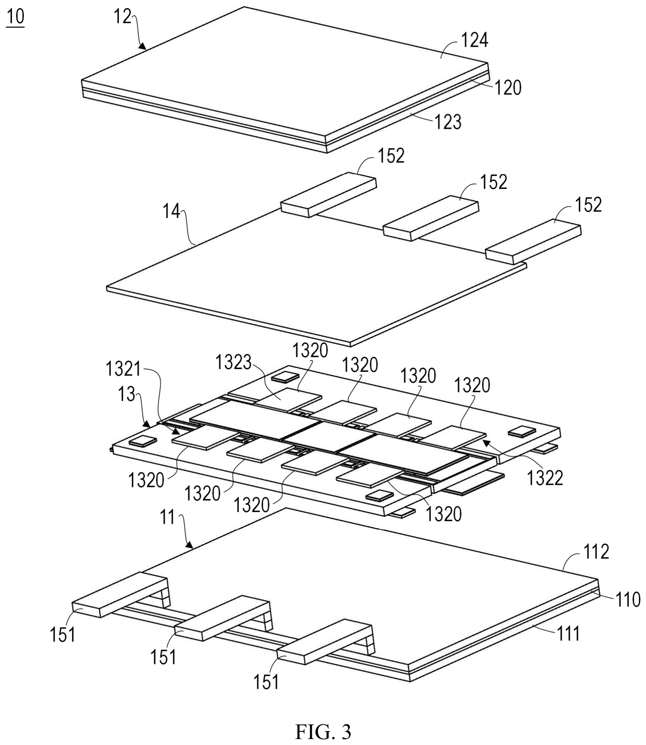

FIG. 1 illustrates a schematic structural diagram of a power module 10 for a solid-state circuit breaker according to some embodiments of the present disclosure, and FIGS. 2 and 3 illustrate exploded schematic diagrams of the power module 10 shown in FIG. 1 along different viewing angles. As shown in FIGS. 1 to 3, the power module 10 described herein generally includes a first substrate 11, a second substrate 12, a chip assembly 13, a terminal connection layer 14, a first terminal 151, and a second terminal 152. The first substrate 11 and the second substrate 12 are stacked on each other. For ease of description, a side on which the first substrate 11 is located may be referred to herein as a bottom-side of the power module 10, and a side on which the second substrate 12 is located may be referred to herein as a top-side of the power module 10. The chip assembly 13 and the terminal connection layer 14 are disposed between the first substrate 11 and the second substrate 12. The chip assembly 13 is disposed between the first substrate 11 and the terminal connection layer 14. The terminal connection layer 14 is disposed between the second substrate 12 and the chip assembly 13. The first terminal 151 is electrically coupled to the first substrate 11, and the second terminal 152 is electrically coupled to the second substrate 12 via the terminal connection layer 14.

The first terminal 151 and the second terminal 152 may be electrically connected in a main loop (not shown) to enable the power module 10 to control an on-off state of the main loop through using the chip assembly 13. For example, when overcurrent or overload occurs in the main loop, a power switching component in the chip assembly 13 may be turned off, thereby cutting off the main loop. Conversely, when the main loop is in a normal operating state, the power switching component in the chip assembly 13 may be turned on, thereby keeping the main loop on.

In an embodiment, as shown in FIGS. 1 to 3, the first terminal 151 may include a plurality of terminal portions, for example, 3 terminal portions. Each terminal portion may be commonly electrically connected to one terminal of the main loop. The plurality of terminal portions can make current distribution more uniform. It should be noted that numbers, values, and the like that may be mentioned above and elsewhere in this disclosure are all exemplary and are not intended to limit the scope of this disclosure in any way. Any other suitable numbers and values are possible. For example, the first terminal 151 may include more or fewer terminal portions, such as 2, 4, 5, etc., and may even include only a single terminal portion.

Similarly, as shown in FIGS. 1 to 3, the second terminal 152 may include a plurality of terminal portions, for example, 3 terminal portions. Each terminal portion may be commonly electrically connected to another terminal of the main loop. It should be understood that the second terminal 152 may include more or fewer terminal portions, such as 2, 4, 5, etc., and may even include only a single terminal portion.

As described above, the second terminal 152 is electrically coupled to the second substrate 12 via the terminal connection layer 14. The terminal connection layer 14 is electrically coupled to the second substrate 12 and the chip assembly 13. In an embodiment, as shown in FIGS. 1 to 3, the second terminal 152 may be directly welded to a top-side of the terminal connection layer 14, that is, a side of the terminal connection layer 14 facing the second substrate 12. The terminal connection layer 14 may help lead out of the second terminal 152. The terminal connection layer 14 may include copper foil or any other suitable metal layer.

Alternatively, in another embodiment, the second terminal 152 may be formed on a side of the terminal connection layer 14 substantially at the same level as the terminal connection layer 14.

Alternatively, in some embodiments, the terminal connection layer 14 may be omitted, and the chip assembly 13 is disposed directly between and electrically coupled to both the first substrate 11 and the second substrate 12. In this case, the second terminal 152 may be directly welded to a bottom-side of the second substrate 12, that is, a side facing the first substrate 11.

Alternatively, in some embodiments, more terminal connection layers 14 may be disposed between the second substrate 12 and the chip assembly 13 for leading out the second terminal 152.

As described above, the first terminal 151 is electrically coupled to the first substrate 11. In an embodiment, as shown in FIGS. 1 to 3, the first terminal 151 may be directly welded to a top-side of the first substrate 11, that is, a side facing the second substrate 12. It should be understood that one or more additional metal connector layers may also be disposed between the first substrate 11 and the chip assembly 13 for leading out the first terminal 151.

In some embodiments, as shown in FIGS. 1 to 3, the first substrate 11 includes a first insulating layer 110, and a first metal layer 111 and a second metal layer 112 disposed on opposite surfaces of the first insulating layer 110. The first terminal 151 may be directly welded to the second metal layer 112. The second metal layer 112 is electrically coupled to the chip assembly 13.

In an embodiment, the first substrate 11 may be a direct bonded copper (DBC) substrate. The DBC substrate includes an aluminum nitride ceramic layer, and an underlying copper metal layer and an overlying copper metal layer disposed on opposite surfaces of the ceramic layer. The underlying copper metal layer corresponds to the first metal layer 111. The overlying copper metal layer corresponds to the second metal layer 112. It should be understood that the first substrate 11 may not adopt a DBC structure, but may adopt a structure in which two sides of an insulating substrate are coated with aluminum, or one side of the insulating substrate is coated with copper and another side of the insulating substrate is coated with a metal such as aluminum, and the scope of the present disclosure is not limited in this respect.

In some embodiments, as shown in FIGS. 1 to 3, the second substrate 12 includes a second insulating layer 120, and a third metal layer 123 and a fourth metal layer 124 disposed on opposite surfaces of the second insulating layer 120. The third metal layer 123 faces the second metal layer 112. The third metal layer 123 may be welded directly to the terminal connection layer 14 or the chip assembly 13.

In an embodiment, the second substrate 12 may also be a direct bonded copper (DBC) substrate with an underlying copper metal layer corresponding to the third metal layer 123 and an overlying copper metal layer corresponding to the fourth metal layer 124. Alternatively, the second substrate 12 may not adopt a DBC structure, but may adopt a structure in which two sides of an insulating substrate are coated with aluminum, or one side of the insulating substrate is coated with copper and another side of the insulating substrate is coated with a metal such as aluminum, and the scope of the present disclosure is not limited in this respect.

In some embodiments, as shown in FIGS. 2 and 3, the chip assembly 13 includes a plurality of bottom-side transistors 1310 and a plurality of top-side transistors 1320. A plurality of bottom-side transistors 1310 are disposed at the bottom of the chip assembly 13. Drains 1313 of the plurality of bottom-side transistors 1310 are electrically coupled to the second metal layer 112 of the first substrate 11. The plurality of bottom-side transistors 1310 includes a first set of bottom-side transistors 1311 and a second set of bottom-side transistors 1312. The plurality of top-side transistors 1320 are disposed on top of the chip assembly 13. Drains 1323 of the plurality of top-side transistors 1320 are electrically coupled to the third metal layer 123 of the second substrate 12 via the terminal connection layer 14. The plurality of top-side transistors 1320 includes a first set of top-side transistors 1321 and a second set of top-side transistors 1322.

In some embodiments, each transistor of the plurality of bottom-side transistors 1310 and the plurality of top-side transistors 1320 may be a SiC transistor. In other embodiments, each of the plurality of bottom-side transistors 1310 and the plurality of top-side transistors 1320 may be other types of transistors, the scope of the present disclosure is not limited in this respect.

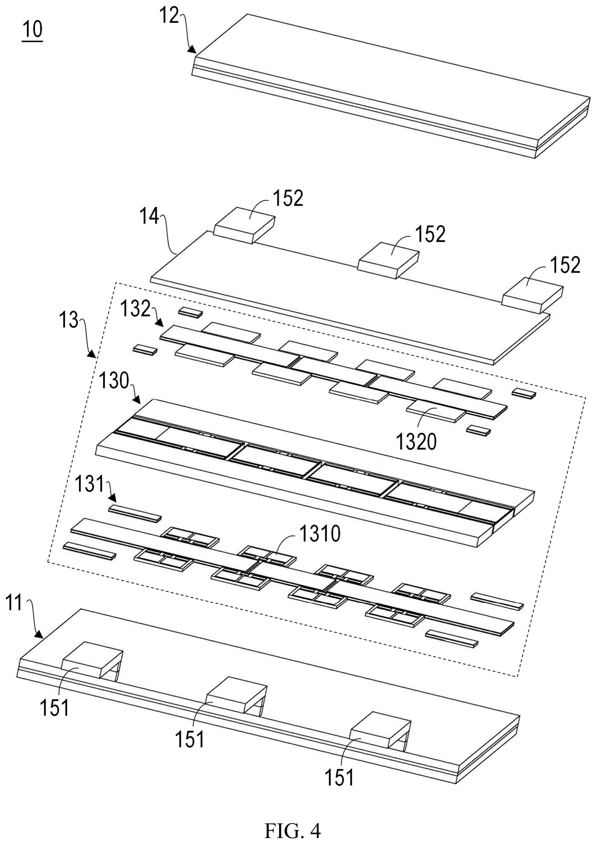

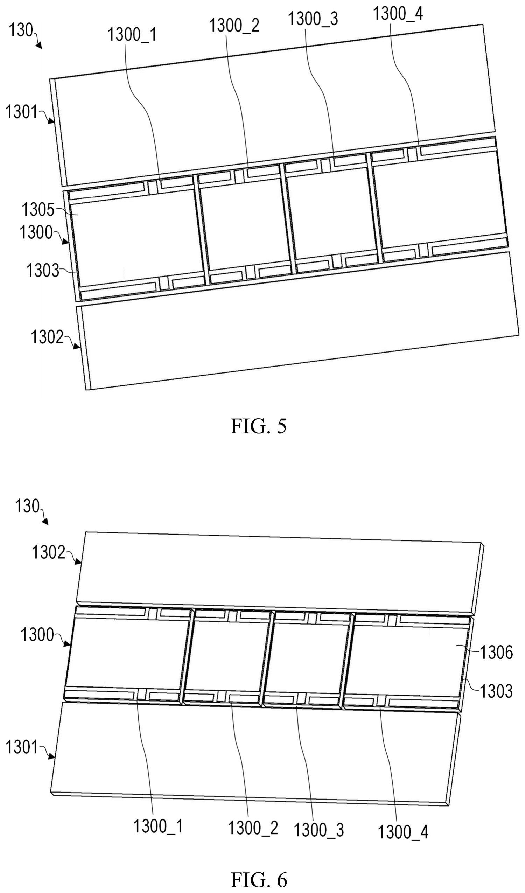

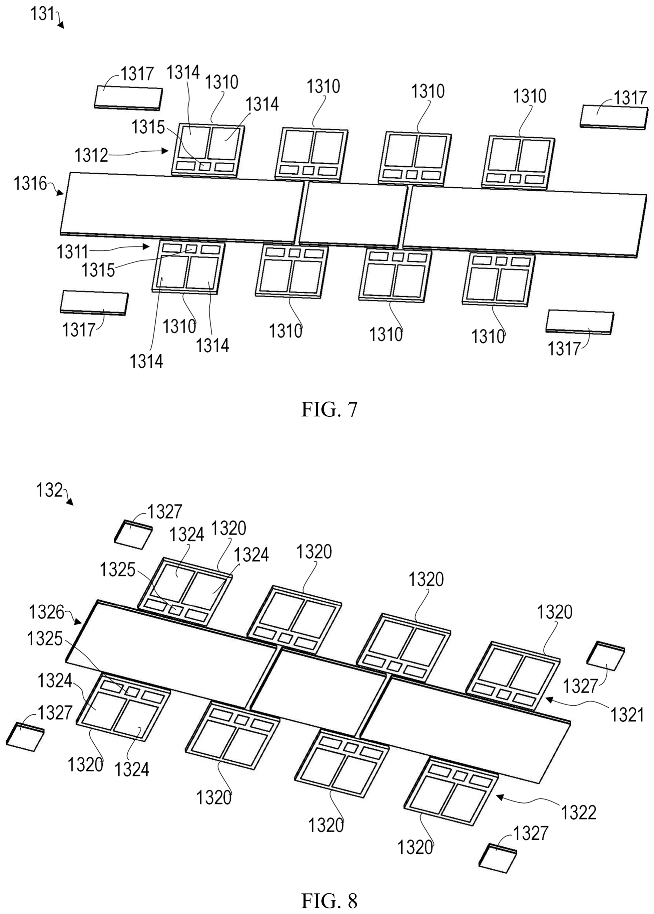

Next, exemplary structures of the chip assembly 13 will be described in conjunction with FIGS. 4 to 8. FIG. 4 illustrates a further exploded schematic view of the power module 10 shown in FIG. 3. FIGS. 5 and 6 illustrate schematic structural diagrams of the intermediate layer 130 of the chip assembly 13 in the power module 10 shown in FIG. 4 along different viewing angles, where FIG. 5 illustrates a side of the intermediate layer 130 facing the first substrate 11, and FIG. 6 illustrates a side of an intermediate layer 130 facing the second substrate 12. FIG. 7 illustrates a schematic structural diagram of a lower layer 131 of the chip assembly 13 in the power module 10 shown in FIG. 4, and FIG. 8 illustrates a schematic structural diagram of an upper layer 132 of the chip assembly 13 in the power module 10 shown in FIG. 4.

In some embodiments, as shown in FIG. 4, the chip assembly 13 may generally form a three-layer structure including an intermediate layer 130, a lower layer 131, and an upper layer 132. The plurality of bottom-side transistors 1310 described above may be disposed in the lower layer 131. The plurality of top-side transistors 1320 described above may be disposed in the upper layer 132. Exemplary structures of the intermediate layer 130, the lower layer 131, and the upper layer 132 will be described next in conjunction with FIGS. 5 to 8.

In some embodiments, as shown in FIGS. 5 and 6, the chip assembly 13 includes a gate drive board 1300 disposed in the intermediate layer 130. The gate driver board 1300 includes a driver board insulating layer 1303, and a bottom-side metal layer 1305 and a top-side metal layer 1306 disposed on opposite surfaces of the driver board insulating layer 1303. The bottom-side metal layer 1305 is electrically coupled to gates 1315 of the plurality of bottom-side transistors 1310 to apply control signals to the gates 1315, as shown in FIGS. 4 to 7. The top-side metal layer 1306 is electrically coupled to the gates 1325 of the plurality of top-side transistors 1320 to apply control signals to the gates 1325, as shown in FIGS. 4 to 8.

In an embodiment, the gate driver board 1300 may be a direct bonded copper (DBC) substrate with an underlying copper metal layer corresponding to the bottom metal layer 1305 and an overlying copper metal layer corresponding to the top metal layer 1306. The gate drive board 1300 may not adopt a DBC structure, but may adopt a structure in which two sides of an insulating substrate are coated with aluminum, or one side of the insulating substrate is coated with copper and another side of the insulating substrate is coated with a metal such as aluminum, and the scope of the present disclosure is not limited in this respect.

In some embodiments, as shown in FIGS. 5 and 6, the chip assembly 13 further includes a first metal connector 1301 and a second metal connector 1302 disposed in the intermediate layer 130. The first metal connector 1301 and the second metal connector 1302 are disposed on opposite sides of the gate drive board 1300. The first metal connector 1301 is electrically coupled to sources 1314 of the first set of bottom-side transistors 1311 and sources 1324 of the first set of top-side transistors 1321, as shown in FIGS. 4 to 8. With this arrangement, individual transistors in the first set of bottom-side transistors 1311 may be connected in parallel, individual transistors in the first set of top-side transistors 1321 may be connected in parallel, and the first set of bottom-side transistors 1311 and the first set of top-side transistors 1321 may be connected in series. The second metal connector 1302 is electrically coupled to the sources 1314 of the second set of bottom-side transistors 1312 and the sources 1324 of the second set of top-side transistors 1322, as shown in FIGS. 4 to 8. With this arrangement, individual transistors in the second set of bottom-side transistors 1312 may be connected in parallel, individual transistors in the second set of top-side transistors 1322 may be connected in parallel, and the second set of bottom-side transistors 1312 and the second set of top-side transistors 1322 may be connected in series. Further, Kelvin electrodes of the top-side transistors 1320 may be led out through the first metal connector 1301 and the second metal connector 1302.

In some embodiments, each of the first metal connectors 1301 and the second metal connectors 1302 includes a copper foil. It should be understood that each of the first metal connector 1301 and the second metal connector 1302 may employ any suitable metal connector, and the scope of the present disclosure is not limited in this respect.

In some embodiments, paraffin is disposed in the copper foil. The paraffin has high heat capacity, and under a condition of absorbing the same heat, temperature rise of the paraffin is lower than that of the copper foil. In this way, heat dissipation performance of the metal connector in a short time can be enhanced, and an overload capability is enhanced.

In some embodiments, as shown in FIGS. 5 and 6, the gate drive board 1300 includes a plurality of segments 1300_1, 1300_2, 1300_3, 1300_4 disposed side-by-side between the first metal connector 1301 and the second metal connector 1302 and spaced apart from each other. The bottom-side metal layer 1305 and the top-side metal layer 1306 of each segment are electrically coupled to gates of the respective bottom-side transistor 1310 and top-side transistor 1320. Each segment may be coupled to a single bottom-side transistor 1310 and a single top-side transistor 1320, or may be coupled to more than two bottom-side transistors 1310 and more than two top-side transistors 1320. Providing the gate drive board 1300 to include multiple segments may improve performance of the chip assembly 13 against mechanical stress, reducing a risk of mechanical structural damage to the chip assembly 13.

In some embodiments, as shown in FIGS. 4 to 8, the power module 10 further includes a bottom-side connector 1316 disposed in the lower layer 131 and a top-side connector 1326 disposed in the upper layer 132. The bottom-side connector 1316 is electrically connected to the bottom-side metal layer 1305 of each of the plurality of segments 1300_1, 1300_2, 1300_3, 1300_4 in order to electrically connect the gates 1315 of the respective bottom-side transistors 1310 together. The top-side connector 1326 is electrically connected to the top-side metal layer 1306 of each of the plurality of segments 1300_1, 1300_2, 1300_3, 1300_4 in order to electrically connect the gates 1325 of the respective top-side transistors 1320 together.

In some embodiments, as shown in FIGS. 7 and 8, the bottom-side connector 1316 includes a plurality of portions for connecting bottom-side metal layers 1305 of adjacent segments, and the top-side connector 1326 includes a plurality of portions for connecting top-side metal layers 1306 of adjacent segments. Alternatively, the bottom-side connector 1316 and the top-side connector 1326 may each be formed as a unitary structure.

In some embodiments, each of the bottom-side connectors 1316 and the top-side connectors 1326 includes a direct bonded copper (DBC) substrate. Of course, the bottom-side connector 1316 and the top-side connector 1326 may also adopt other structures, for example, a structure in which two sides of the insulating substrate are coated with aluminum, or one side of the insulating substrate is coated with copper and another side of the insulating substrate is coated with a metal such as aluminum, and the scope of the present disclosure is not limited in this respect.

Alternatively, in some embodiments, the gate drive board 1300 may be a unitary structure to electrically couple to the gates 1315 of the plurality of bottom-side transistors 1310 and the gates 1325 of the plurality of top-side transistors 1320. In this case, the bottom-side connector 1316 and the top-side connector 1326 need not be provided again.

In some embodiments, as shown in FIGS. 4 to 8, the power module 10 further includes a plurality of top-side spacers 1327. The plurality of top-side spacers 1327 are disposed between the terminal connection layer 14 and each of the first metal connector 1301 and the second metal connector 1302.

In some embodiments, as shown in FIGS. 4 to 8, the power module 10 further includes a plurality of bottom-side spacers 1317. The plurality of bottom-side spacers 1317 are disposed between the first substrate 11 and each of the first metal connector 1301 and the second metal connector 1302.

Each of the plurality of bottom-side spacers 1317 and the plurality of top-side spacers 1327 may be a direct bonded copper (DBC) substrate or other types of structures, for example, a structure in which two sides of the insulating substrate are coated with aluminum, or one side of the insulating substrate is coated with copper and another side of the insulating substrate is coated with a metal such as aluminum. The Kelvin electrodes of the bottom-side transistors 1310 may be led out through a metal layer on the bottom-side spacers 1317.

The power module 10 of the embodiment of the present disclosure can achieve a bidirectional turn-off function with a small on-resistance, and is suitable for being applied to a solid-state circuit breaker.

In addition, parasitic parameters of the power module 10 of embodiments of the present disclosure can be reduced to a lower level, thereby significantly improving current balancing performance. It has been found that since the stacked structure is adopted, a current difference of the transistors in the power module 10 of embodiments of the present disclosure is substantially within 1 ampere, while a current difference of transistors in a conventional power module can be up to several hundred amperes.

In addition, the power module 10 of the embodiment of the present disclosure can achieve double-sided heat dissipation of each transistor, thereby optimizing thermal resistance and heat capacity, improving heat dissipation performance, and achieving better overload capability. It has been found that, compared with the conventional power module, temperature of a chip of the power module 10 of embodiments of the present disclosure is significantly reduced to 10 °C. or above under an overload condition.

In addition, an integration level of the power module 10 of embodiments of the present disclosure is significantly improved, the power module 10 can be manufactured to be smaller in size, and better turn-off performance can be achieved by using fewer transistors. It has been found that, in a case where the same performance requirements are met, the number of transistors required by the power module 10 of the embodiments of the present disclosure may be reduced to some extent, for example, from 20 original transistors to 16 transistors, and the volume can be significantly reduced, or even reduced by 75%.

Furthermore, cost of the power module 10 of embodiments of the present disclosure can be significantly reduced by about 30%.

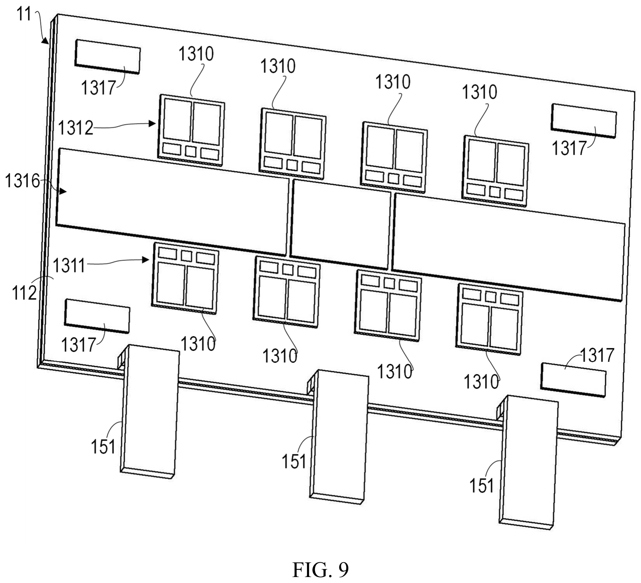

Next, an example manufacturing process of the power module 10 according to some embodiments of the present disclosure will be described in conjunction with FIGS. 9 to 14.

As shown in FIG. 9, a first substrate 11 is provided, and a plurality of bottom-side transistors 1310, a bottom-side connector 1316, and a plurality of bottom-side spacers 1317 are attached to the first substrate 11. The first substrate 11, the bottom-side connectors 1316, and the plurality of bottom-side spacers 1317 may all be DBC substrates or other types of substrates. Further, the first terminal 151 may be welded to the second metal layer 112 on the first substrate 11.

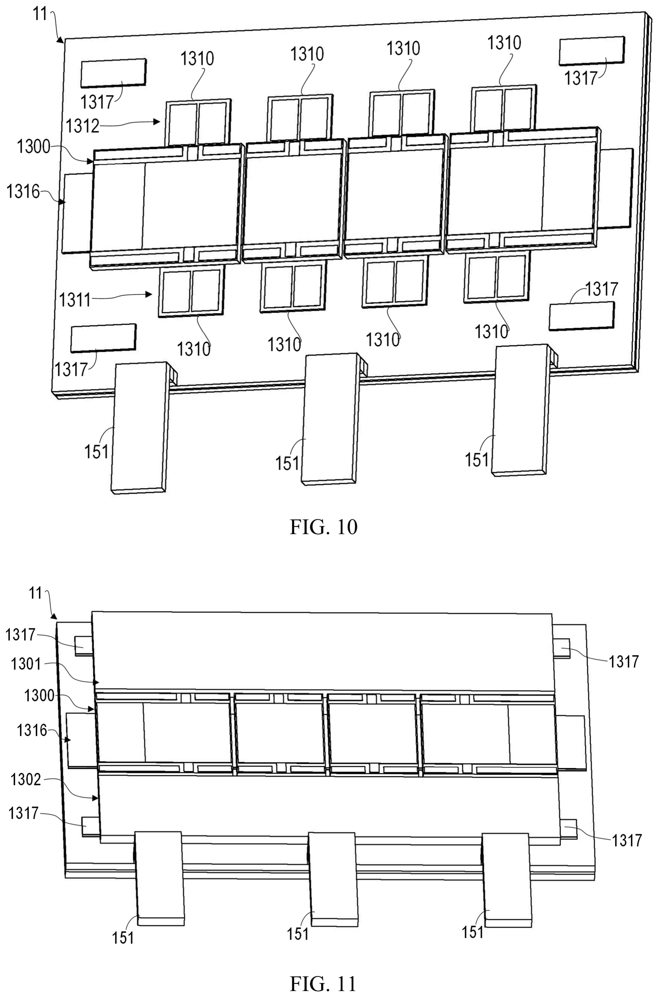

As shown in FIG. 10, a gate drive board 1300 is formed over the bottom-side connector 1316. The gate drive board 1300 may be a DBC substrate or other type of substrate. A bottom-side metal layer 1305 of the gate drive board 1300 is electrically coupled to gates 1315 of the plurality of bottom-side transistors 1310 and to the bottom-side connectors 1316. The gates 1315 of the plurality of bottom-side transistors 1310 may be led out through the bottom-side connectors 1316.

As shown in FIG. 11, a first metal connector 1301 and a second metal connector 1302 are formed on opposite sides of the gate drive board 1300. The first metal connector 1301 is electrically coupled to sources 1314 of a first set of bottom-side transistors 1311. The second metal connector 1302 is electrically coupled to the sources 1314 of a second set of bottom-side transistors 1312. Kelvin electrodes of the bottom-side transistor 1310 may be led out through a metal layer on the bottom-side spacers 1317.

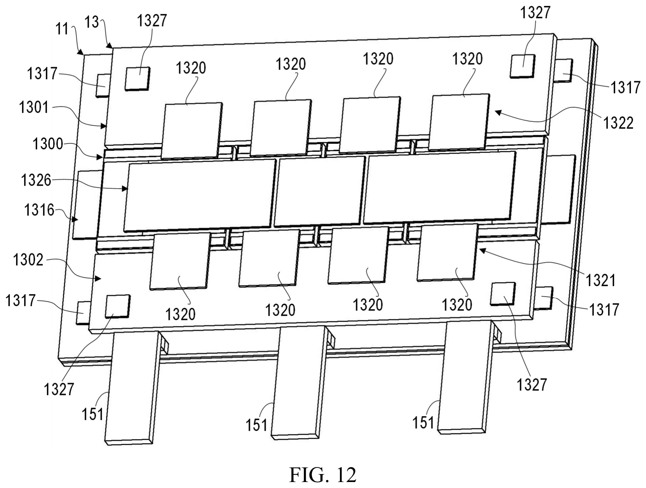

As shown in FIG. 12, a plurality of top-side transistors 1320, a top-side connector 1326, and a plurality of top-side spacers 1327 are formed over a gate drive board 1300, a first metal connector 1301, and a second metal connector 1302. The top-side connector 1326 and the plurality of top-side spacers 1327 may each be a DBC substrate or other type of substrate. Gates 1325 of the plurality of top-side transistors 1320 are electrically coupled to a top-side metal layer 1306 of the gate drive board 1300. Sources 1324 of a first set of top-side transistors 1321 are electrically coupled to the first metal connectors 1301. Sources 1324 of a second set of top-side transistors 1322 are electrically coupled to the second metal connector 1302. The plurality of top-side spacers 1327 are formed on the first metal connector 1301 and the second metal connector 1302. The top-side connector 1326 is electrically coupled to the top-side metal layer 1306 of the gate drive board 1300. Gates 1325 of the plurality of top-side transistors 1320 may be led out through the top-side connector 1326. Kelvin electrodes of the top-side transistors 1320 may be led out through the first metal connector 1301 and the second metal connector 1302.

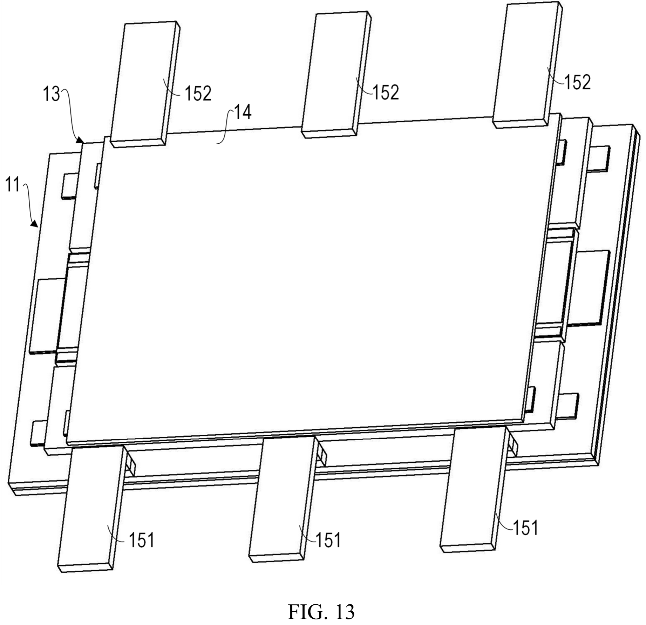

As shown in FIG. 13, a terminal connection layer 14 is formed over a plurality of top-side transistors 1320. The terminal connection layer 14 may be a copper foil or any other type of connection layer. The terminal connection layer 14 is electrically coupled to drains 1323 of the plurality of top-side transistors 1320. Further, a second terminal 152 may be welded to the terminal connection layer 14.

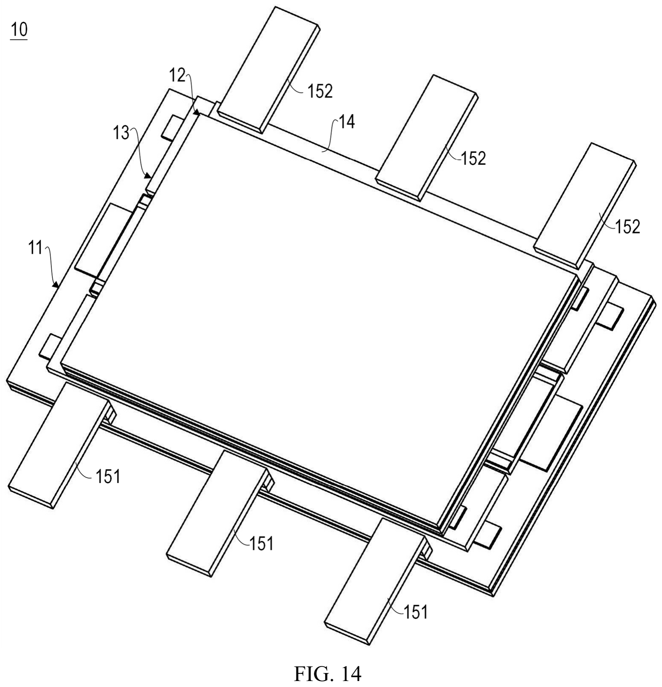

As shown in FIG. 14, a second substrate 12 is formed on a terminal connection layer 14. The second substrate 12 may be a DBC substrate or other types of substrates. When the heat sink is added, the second substrate 12 can improve insulation performance.

Embodiments of the present disclosure have been described above, and the above description is exemplary, not exhaustive, and is not limited to the disclosed embodiments. Many modifications and variations will be apparent to those of ordinary skill in the art without departing from the scope of the illustrated embodiments. The selection of terms as used herein is intended to best explain the principles of embodiments, the practical application or technical improvements to the market, or to enable others of ordinary skill in the art to understand the embodiments disclosed herein.

## Claims

1. A power module (10) for a solid-state circuit breaker, comprising:
a first substrate (11) and a second substrate (12) stacked on each other;
a first terminal (151) electrically coupled to the first substrate (11) and a second terminal (152) electrically coupled to the second substrate (12); and
a chip assembly (13) disposed between the first substrate (11) and the second substrate (12), and comprising:
a plurality of bottom-side transistors (1310) having drains electrically coupled to the first substrate (11) and comprising a first set of bottom-side transistors (1311) and a second set of bottom-side transistors (1312);
a plurality of top-side transistors (1320) having drains electrically coupled to the second substrate (12) and comprising a first set of top-side transistors (1321) and a second set of top-side transistors (1322);
a gate drive board (1300) comprising a drive board insulating layer (1303), and a bottom-side metal layer (1305) and a top-side metal layer (1306) disposed on opposite surfaces of the drive board insulating layer (1303), the bottom-side metal layer (1305) being electrically coupled to gates of the plurality of bottom-side transistors (1310), the top-side metal layer (1306) being electrically coupled to gates of the plurality of top-side transistors (1320); and
a first metal connector (1301) and a second metal connector (1302) disposed on opposite sides of the gate drive board (1300), the first metal connector (1301) being electrically coupled to sources of the first set of bottom-side transistors (1311) and the first set of top-side transistors (1321), the second metal connector (1302) being electrically coupled to sources of the second set of bottom-side transistors (1312) and the second set of top-side transistors (1322).

2. The power module (10) of claim 1, wherein the first substrate (11) comprises a first insulating layer (110), and a first metal layer (111) and a second metal layer (112) disposed on opposite surfaces of the first insulating layer (110), the second metal layer (112) being electrically coupled to drains of the plurality of bottom-side transistors (1310); and
wherein the second substrate (12) comprises a second insulating layer (120), and a third metal layer (123) and a fourth metal layer (124) disposed on opposite surfaces of the second insulating layer (120), the third metal layer (123) facing the second metal layer (112) and being electrically coupled to drains of the plurality of top-side transistors (1320).

3. The power module (10) of claim 2, wherein each of the first substrate (11) and the second substrate (12) comprises a direct bonded copper (DBC) substrate, and/or
the first terminal (151) is electrically coupled to the second metal layer (112).

4. The power module (10) of claim 2, further comprising:
a terminal connection layer (14) disposed between the second substrate (12) and the chip assembly (13) and electrically coupled to the third metal layer (123) and the drains of the plurality of top-side transistors (1320), wherein the second terminal (152) is electrically coupled to the terminal connection layer (14).

5. The power module (10) of claim 4, wherein the terminal connection layer (14) comprises a copper foil.

6. The power module (10) of claim 4, further comprising:
a plurality of top-side spacers (1327) disposed between the terminal connection layer (14) and each of the first metal connector (1301) and the second metal connector (1302).

7. The power module (10) of claim 1, further comprising:
a plurality of bottom-side spacers (1317) disposed between the first substrate (11) and each of the first metal connector (1301) and the second metal connector (1302).

8. The power module (10) of claim 7, wherein Kelvin electrodes of the plurality of bottom-side transistors (1310) are led out through metal layers on the plurality of bottom-side spacers (1317), and Kelvin electrodes of the plurality of top-side transistors (1320) are led out through the first metal connector (1301) and the second metal connector (1302).

9. The power module (10) of claim 1, wherein the gate drive board (1300) comprises a plurality of segments (1300_1, 1300_2, 1300_3, 1300_4) disposed side-by-side between the first metal connector (1301) and the second metal connector (1302) and spaced apart from each other; and
wherein the power module (10) further comprises a bottom-side connector (1316) electrically connected to the bottom-side metal layer (1305) of each of the plurality of segments (1300_1, 1300_2, 1300_3, 1300_4) and a top-side connector (1326) electrically connected to the top-side metal layer (1306) of each of the plurality of segments (1300_1, 1300_2, 1300_3, 1300_4).

10. The power module (10) of claim 9, wherein the bottom-side connector (1316) comprises a plurality of portions for connecting the bottom-side metal layer (1305) of adjacent segments and the top-side connector (1326) comprises a plurality of portions for connecting the top-side metal layer (1306) of adjacent segments.

11. The power module (10) of claim 9, wherein each of the gate drive board (1300), the bottom-side connector (1316), and the top-side connector (1326) comprises a direct bonded copper (DBC) substrate, and/or
the gates of the plurality of bottom-side transistors (1310) are led out through the bottom-side connector (1316), and the gates of the plurality of top-side transistors (1320) are led out through the top-side connector (1326).

12. The power module (10) of claim 1, wherein each of the first metal connector (1301) and the second metal connector (1302) comprises a copper foil.

13. The power module (10) of claim 12, wherein paraffin is disposed inside the copper foil.

14. The power module (10) of any of claims 1 to 13, wherein each of the plurality of bottom-side transistors (1310) and the plurality of top-side transistors (1320) is a SiC transistor.

15. A solid-state circuit breaker comprising the power module (10) of any claims 1 to 14.
